# EUROPEAN PATENT APPLICATION

(11) **EP 4 813 955 A1**
(43) Date of publication of application: **30.09.2026**
(21) Application number: 24894082.7
(22) Date of filing: 15.11.2024
(51) Int. Cl.: C04B 35/587, H01L 23/15, H01L 23/373

(54) **SILICON NITRIDE-BASED SINTERED BODY AND SILICON NITRIDE-BASED HEAT DISSIPATION SUBSTRATE**

(30) Priority: 22.11.2023 JP 2023197832
(71) Applicant: Niterra Co., Ltd., Nagoya-shi, Aichi 461-0005 (JP)
(72) Inventor: MOTEKI, Jun, Nagoya-shi, Aichi 461-0005 (JP); IHARA, Akio, Nagoya-shi, Aichi 461-0005 (JP); IKAI, Yoshihito, Nagoya-shi, Aichi 461-0005 (JP); MITSUOKA, Takeshi, Nagoya-shi, Aichi 461-0005 (JP)
(74) Representative: Grünecker Patent- und Rechtsanwälte PartG mbB
(86) International application number: PCT/JP2024/040562
(87) International publication number: WO 2025/110091

(57) **Abstract**

To provide a silicon nitride-based sintered body and a silicon nitride-based heat radiation substrate which achieve both high thermal conductivity and high mechanical strength. The silicon nitride-based sintered body mainly including silicon nitride-based grains and a grain boundary phase surrounding the silicon nitride-based grains. In a cross-section of the silicon nitride-based sintered body, the ratio of the area of the grain boundary phase to the entire area of the cross-section is 1% or greater and 10% or less; the grain boundary phase is formed of an amorphous region A and a crystalline region C; the area ratio of the area of the crystalline region C with respect to the area of the grain boundary phase, C/(A+C)×100, falls within a range of 20% or greater and 70% or less; and a crystal phase forming the crystalline region C at least includes one or more of an M phase, a J phase, a monosilicate phase, and a disilicate phase.

## Description

### TECHNICAL FIELD

The present invention relates to a silicon nitride-based sintered body and to a silicon nitride-based heat radiation substrate.

### BACKGROUND ART

Silicon nitride, having high thermal conductivity and mechanical strength, attracts attention as a material for electrically insulating heat radiation substrates of power modules for inverters installed in electric vehicles (EVs) and hybrid vehicles (HVs). Conventionally, aluminum nitride has been widely used as a material of electrically insulating heat radiation substrates. However, in the case of a power module for large current such as that for EVs, the temperature of the power module rises to about 250°C, and a large thermal stress is generated in its substrate due to the difference in thermal expansion between the substrate and a metal such as copper bonded thereto. As a result, the substrate formed of aluminum nitride having low mechanical strength is cracked or broken. Therefore, silicon nitride, which among general insulating ceramic materials is high in thermal conductivity and has higher mechanical strength, has been employed in an increasing number of cases, although the thermal conductivity of silicon nitride is lower than that of aluminum nitride.

Patent Document 1 discloses a silicon nitride ceramic characterized by containing Mg oxide and Ce oxide in a total amount of 5 to 15 wt% at a weight ratio of 5:4 to 4:1 as reduced to MgO and CeO₂, the balance being silicon nitride, wherein the ceramic has crystal grains of silicon nitride which assume acicular grains having a shorter axis diameter of 1 µm or less, an amorphous grain boundary, and a porosity of 0.5% or less.

Patent Document 2 discloses a silicon nitride sintered body composed of silicon nitride and a grain boundary phase which is formed of a sintering aid, wherein the grain boundary phase has an amorphous structure.

### PRIOR ART DOCUMENTS

### PATENT DOCUMENTS

Patent Document 1: JPH07-267735A
Patent Document 2: JP2022-166444A

### SUMMARY OF THE INVENTION

### PROBLEM TO BE SOLVED BY THE INVENTION

The silicon nitride sintered body disclosed in Patent Document 1 or 2 is formed of silicon nitride grains and a grain boundary phase which is mainly formed of an amorphous material. This technical feature is provided in order to enhance mechanical strength. The documents disclose a mechanical strength of 600 MPa or higher which has been achieved by a mechanism including grain boundary enhancement, filling voids with an amorphous material, and the like.

Silicon nitride is a high thermal conductivity material with a reported theoretical thermal conductivity, for example, higher than 200 W/mK. The higher the thermal conductivity of silicon nitride material, the better the heat radiation performance. Meanwhile, the amorphous phase generally has low thermal conductivity, and the value thereof is reportedly as low as about 1 W/mK. When the grain boundary phase is substantially formed of an amorphous material according to the technique disclosed in Patent Document 1 or 2, the thermal conductivity of the silicon nitride material decreases. Thus, such a silicon nitride material conceivably fails to exert satisfactory heat radiation performance possessed by a heat radiation substrate.

The present inventors have conducted extensive studies and have found that, even in the case of a silicon nitride-based sintered body including a grain boundary phase, a silicon nitride-based sintered body achieving both high thermal conductivity and high mechanical strength can be obtained by adjusting the area ratio of the grain boundary phase and the area ratio of the crystalline region present in the grain boundary phase to fall within specific ranges, so that a particular crystal is incorporated into the crystals forming the crystalline region. The present invention has been accomplished on the basis of this finding.

The present invention has been conceived under such circumstances. Thus, an object of the invention is to provide a silicon nitride-based sintered body and a silicon nitride-based heat radiation substrate which achieve both high thermal conductivity and high mechanical strength.

### MEANS FOR SOLVING THE PROBLEMS

(1) In order to attain the aforementioned object, the present invention provides a silicon nitride-based sintered body with the following technical means. Accordingly, an application example of the silicon nitride-based sintered body of the present invention is directed to a silicon nitride-based sintered body mainly comprising silicon nitride-based grains and a grain boundary phase surrounding the silicon nitride-based grains, wherein, in a cross-section of the silicon nitride-based sintered body, a ratio of the area of the grain boundary phase to the entire area of the cross-section is 1% or greater and 10% or less; the grain boundary phase is formed of an amorphous region A and a crystalline region C; an area ratio of the area of the crystalline region C with respect to the area of the grain boundary phase, C/(A+C)×100, falls within a range of 20% or greater and 70% or less; and a crystal phase forming the crystalline region C at least includes one or more of an M phase, a J phase, a monosilicate phase, and a disilicate phase.
(2) In the silicon nitride-based sintered body according to the application example (1) above, Al is included in an amount greater than 0 ppm and 650 ppm or less.
(3) An application example of the silicon nitride-based heat radiation substrate of the present invention is formed of a silicon nitride-based sintered body according to (1) or (2) above.
(4) In the silicon nitride-based heat radiation substrate according to the application example (3) above, thermal conductivity is 85 W/mK or higher.
(5) In the silicon nitride-based heat radiation substrate according to the application example (3) or (4) above, flexural strength is 500 MPa or higher.
(6) In the silicon nitride-based heat radiation substrate according to any of the application examples (3) to (5) above, a thickness in a direction perpendicular to one main face of the silicon nitride-based heat radiation substrate is 220 µm or more and 690 µm or less.

### EFFECTS OF THE INVENTION

According to the silicon nitride-based sintered body or the silicon nitride-based heat radiation substrate of the present invention, there can be provided a silicon nitride-based sintered body or a silicon nitride-based heat radiation substrate which achieves both high thermal conductivity and high mechanical strength.

### BRIEF DESCRIPTION OF THE DRAWINGS

[FIG. 1] A schematic perspective view showing an example of a silicon nitride-based heat radiation substrate according to an embodiment of the present invention.
[FIG. 2] A schematic cross-sectional view showing an example of a power device employing the silicon nitride-based heat radiation substrate according to an embodiment of the present invention.
[FIG. 3] A table showing characteristics of the grain boundary phase of each sample, the substance forming the crystalline region, and characteristics of each sample.

### MODES FOR CARRYING OUT THE INVENTION

Embodiments of the present invention will now be described with reference to the drawings. In order to facilitate understanding of description, identical constituent elements in the drawings are denoted by the same reference numerals, and their redundant descriptions are omitted. Notably, in structural views, the sizes of constituent elements are conceptually represented and do not necessarily represent the actual dimensional ratios.

### [Embodiments]

### [structure of silicon nitride-based sintered body]

Firstly, an embodiment of the silicon nitride-based sintered body of the present invention will be described. The silicon nitride-based sintered body according to the embodiment of the present invention is a silicon nitride-based sintered body mainly comprising silicon nitride-based grains and a grain boundary phase surrounding the silicon nitride-based grains. The term "silicon nitride-based grains" refers to silicon nitride grains or Sialon grains. However, since Sialon provides a lower thermal conductivity as compared with silicon nitride, the amount of Sialon is preferably adjusted to that generated within a range of the below-mentioned Al content as the upper limit. The expression "mainly comprising silicon nitride-based grains and a grain boundary phase surrounding the silicon nitride-based grains" allows presence of an impurity other than the below-mentioned elements of 0.5 wt% or less.

In a cross-section of the silicon nitride-based sintered body, the ratio of the area of the grain boundary phase to the entire area of the cross-section is 1% or greater and 10% or less. Also, the grain boundary phase is formed of an amorphous region A and a crystalline region C, and the area ratio of the area of the crystalline region C with respect to the area of the grain boundary phase, C/(A+C)×100, falls within a range of 20% or greater and 70% or less. The crystal phase forming the crystalline region C at least includes one or more of an M phase, a J phase, a monosilicate phase, and a disilicate phase.

The percent area ratio of the grain boundary phase may be determined through observation under a scanning electron microscope (SEM). In a specific procedure, a silicon nitride-based sintered body is processed through ion milling, and five sites in the processed surface are selected at random. A vision field (50 µm × 50 µm) at each site is observed at a magnification of 2,000. Areas of regions or grains which are recognized as the grain boundary phase observed in the five vision fields of the five sites are summed, and the ratio of the summed area to the entire area of the vision fields is calculated, to thereby determine a percent area ratio of the grain boundary phase. The area ratio may be calculated by means of image analysis software such as Winroof.

The area ratio of the crystalline region C in the grain boundary phase may be determined through observation under a scanning transmission electron microscope (STEM). In a specific procedure, the same processed surface as employed in observation through SEM is observed under a STEM, and electron diffraction analysis is conducted with respect to the grain boundary phase, whereby the crystalline feature or amorphous feature of the grain boundary phase can be determined. Thus, it can be determined that the grain boundary phase is formed of the amorphous region A and the crystalline region C, and there can be calculated the area ratio of the area of the crystalline region C with respect to the area of the grain boundary phase, C/(A+C)×100.

The crystal phase which forms the crystalline region C in the grain boundary phase may be identified on the basis of the results of X-ray diffraction (XRD). The term "M phase" refers to a crystal identified by No. 00-045-0249 in the PDF (powder diffraction file) card. The M phase is also called a melilite phase and assumes a Y₂Si₃O₃N₄-type crystal. The term "J phase" refers to a crystal identified by No. 01-086-1106 in the PDF card. The J phase assumes a Y₄Si₂O₇N₂-type crystal. The term "monosilicate phase" refers to a crystal identified by No. 00-052-181 in the PDF card. The monosilicate phase is also called an m phase and assumes a Y₂SiO₅-type crystal. The term "disilicate phase" refers to a crystal identified by No. 01-072-359 in the PDF card. The disilicate phase is also called a d phase and assumes a Y₂Si₂O₇-type crystal. In each case, a typical composition of the corresponding crystal is shown. However, a constituting element may vary when the crystal system, the space group, and configuration of the constituting elements are the same. For example, the M phase may also be Yb₂Si₃O₃N₄.

The grain boundary phase, or the amorphous region A or the crystalline region C forming the grain boundary phase is formed in the sintered body in a delocalized manner. The percent area ratio of the grain boundary phase or the area ratio of the crystalline region in a SEM image of a processed surface of the silicon nitride-based sintered body obtained through ion milling can be regarded as the corresponding volume ratio in the silicon nitride-based sintered body.

The silicon nitride-based sintered body preferably has an Al content greater than 0 ppm and 650 ppm or less. Al is an impurity originating from a raw material. Through incorporation of Al thereinto, sinterability to yield a silicon nitride-based sintered body is enhanced, to thereby enhance the mechanical strength of the silicon nitride-based sintered body. Also, when the Al content falls within the range, a drop in thermal conductivity caused by formation of Sialon is suppressed to a substantially negligible level. When the Al content is in excess of 650 ppm, the Sialon content of the silicon nitride-based sintered body increases, to thereby evoke a drop in thermal conductivity of the silicon nitride-based sintered body in some cases.

The silicon nitride-based sintered body preferably contains a rare earth element. Since a rare earth element mainly contributes to formation of a grain boundary phase, the rare earth element content is preferably adjusted to a level required for forming the grain boundary phase. The specific amount of the rare earth element varies depending on the composition of a compound forming the amorphous region A or the crystalline region C. For example, the total rare earth element is preferably 1.0 to 7.5 wt%. When the rare earth element content is less than the lower limit of the range, sinterability decreases, and pores remain, resulting in a drop in mechanical strength of the silicon nitride-based sintered body in some cases. When the rare earth element content is higher than the upper limit of the range, the amount of the grain boundary phase increases, resulting in a drop in thermal conductivity of the silicon nitride-based sintered body in some cases. Regardless of the species of the rare earth element contained in the silicon nitride-based sintered body, the same effect can be conceivably achieved. The rare earth element may be, for example, yttrium (Y), lanthanum (La), erbium (Er), or ytterbium (Yb).

Also preferably, the silicon nitride-based sintered body contains an alkali metal element or an alkaline earth metal element. Through incorporation of an alkali metal element or an alkaline earth metal element thereinto, sinterability to yield a silicon nitride-based sintered body is enhanced, to thereby enhance the mechanical strength of the silicon nitride-based sintered body. For example, the silicon nitride-based sintered body preferably contains an alkali metal element or an alkaline earth metal element in a total amount of 0.25 to 2.0 wt%. When the alkali metal element content or the alkaline earth metal element content is lower than the lower limit of the range, the mechanical strength of the silicon nitride-based sintered body decreases in some cases. When the alkali metal element content or the alkaline earth metal element content is higher than the upper limit of the range, the thermal conductivity of the silicon nitride-based sintered body decreases in some cases.

The silicon nitride-based sintered body preferably contains a group 4 element. For example, the silicon nitride-based sintered body preferably contains a group 4 element in a total amount of 0.30 to 3.0 wt%. In this case, the group 4 element may form a compound containing at least one of nitrogen and carbon. The group 4 element, which does not form a solid solution with silicon nitride, does not evoke a drop in thermal conductivity caused by phonon scattering. In addition, the group 4 element does not form a solid solution with the grain boundary phase formed via reaction between a rare earth element and silicon nitride. Therefore, the group 4 element alone easily forms a compound, and residual pores are filled with the compound. As a result, the mechanical strength of the silicon nitride-based sintered body is enhanced. In addition, particles of a compound containing a group 4 element and at least one of nitrogen and carbon suppresses propagation of cracking, thereby leading to high toughness. Notably, the "compound containing a group 4 element and at least one of nitrogen and carbon" encompasses a compound containing only a group 4 element and nitrogen or carbon; a compound containing a group 4 element, nitrogen, and carbon; and such a compound forming a solid solution with another group 4 element or an anion (e.g., oxygen), so long as the intrinsic crystal structure is stable.

By virtue of the aforementioned technical features, the silicon nitride-based sintered body can exhibit higher mechanical strength, while high thermal conductivity is maintained.

### [Configuration of silicon nitride-based heat radiation substrate]

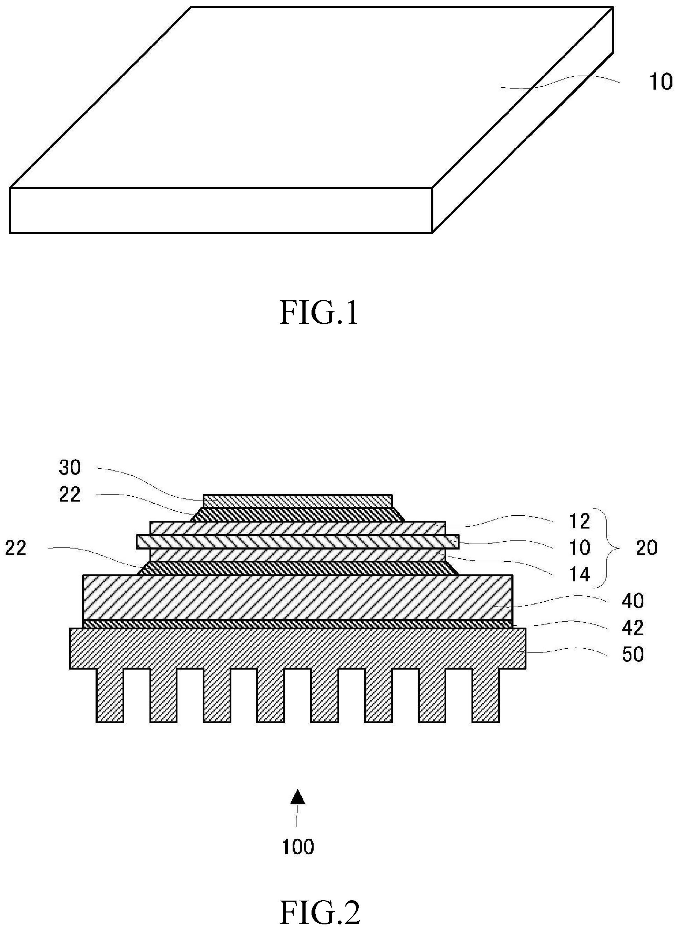

FIG. 1 is a schematic perspective view showing an example of a silicon nitride-based heat radiation substrate according to an embodiment of the present invention. A silicon nitride-based heat radiation substrate 10 according to the present invention is formed of the aforementioned silicon nitride-based sintered body. Thus, high mechanical strength can be achieved, while high thermal conductivity is maintained. As a result, occurrence of any failure in a circuit substrate employing the heat radiation substrate can be reduced. The silicon nitride-based heat radiation substrate 10 of the present invention can be suitably used as a heat radiation substrate of a circuit substrate for power devices. The silicon nitride-based heat radiation substrate 10 is shaped into, for example, a plate.

The silicon nitride-based heat radiation substrate 10 preferably has a flexural strength of 500 MPa or higher. In this case, breaking of the silicon nitride-based heat radiation substrate 10 can be suppressed.

The flexural strength can be measured through the following procedure. Specifically, in accordance with ISO 23242, a silicon nitride-based heat radiation substrate is processed to specific dimensions of (fixed thickness) × 12 × 25 mm, and flexural strength is measured with a span of 15 mm by a three-point bending method. ISO 23242 may be applied to a ceramic thin plate having a thickness of 0.2 mm to 1.0 mm.

Preferably, the silicon nitride-based heat radiation substrate 10 has a thermal conductivity of 85 W/mK or higher. In this case, the performance as a heat radiation substrate can be fully achieved.

Thermal conductivity may be calculated in the following manner. Firstly, a silicon nitride-based heat radiation substrate 10 is processed into pieces having dimensions of 0.32 mm × 17 mm × 17 mm. Thermal diffusivity of each piece is measured through a 2-dimensional method based on the laser flash method. Also, the density of the silicon nitride-based heat radiation substrate 10 is measured in accordance with a method according to JIS R1634. Specific heat is fixed at a constant value of 0.68 cm²/sec. From the thus-obtained thermal diffusivity and density, thermal conductivity can be calculated by an equation: (thermal conductivity)=(density)×(specific heat)×(thermal diffusivity).

Preferably, the silicon nitride-based heat radiation substrate 10 has a thickness in a direction perpendicular to its one main face of 220 µm or more and 690 µm or less. In this case, the mechanical strength and heat radiation performance of the silicon nitride-based heat radiation substrate 10 can be achieved in a well-balanced manner. When the thickness is less than the lower limit of the range, the mechanical strength of the substrate decreases in some cases, whereas the thickness is greater than the upper limit of the range, heat radiation performance decreases in some cases.

### [Configuration of power device]

FIG. 2 is a schematic cross-sectional view showing an example of a power device employing the silicon nitride-based heat radiation substrate according to an embodiment of the present invention. A power device 100 has a circuit substrate 20, a power semiconductor 30, a heat radiation plate 40, and a heat radiation member 50.

The circuit substrate 20 has a circuit layer 12 formed on one main face of the silicon nitride-based heat radiation substrate 10, and a conductor layer 14 formed on the face opposing to the one main face. The circuit layer 12 and the conductor layer 14 are preferably formed of a metal, more preferably a metal mainly containing copper. The circuit layer 12 and the conductor layer 14 are joined directly to the silicon nitride-based heat radiation substrate 10 or by the mediation of a joining material such as braze.

On the circuit layer 12 of the circuit substrate 20, a power semiconductor 30 is mounted. The power semiconductor 30 and the circuit layer 12 may be joined together by use of a solder 22 or the like. The power semiconductor 30 may be formed of, for example, a semiconductor which allows passage of large current for EVs and is easily heated to high temperature. Since the silicon nitride-based heat radiation substrate 10 of the present invention exhibits high mechanical strength while high thermal conductivity is maintained, generation of cracking or the like is prevented, even when large thermal stress is generated in the silicon nitride-based heat radiation substrate 10 due to the high temperature-induced difference in thermal expansion between the silicon nitride-based heat radiation substrate 10 and the joining metal.

To the lower face of the conductor layer 14 of the circuit substrate 20, a heat radiation plate 40 is joined. The heat radiation plate 40 and the conductor layer 14 may be bonded together by use of a solder 22 or the like. The face opposite to the face joined to the conductor layer 14 of the heat radiation plate 40 is in contact with a heat radiation member 50 via a grease 42. The heat radiation plate 40 is preferably formed of a metal, more preferably a metal mainly containing copper. The heat radiation member 50 is provided with heat radiation fins. The heat radiation member 50 is preferably formed of a metal, more preferably a metal mainly containing copper or aluminum.

### [Method of manufacturing silicon nitride-based sintered body and silicon nitride-based heat radiation substrate]

An example of a method of manufacturing the silicon nitride-based sintered body and the silicon nitride-based heat radiation substrate will be described. Firstly, essential members are selected from the powder raw materials of the silicon nitride-based sintered body, and weighed to attain the target composition. The powder raw materials of the silicon nitride-based sintered body may be an oxide, a carbonate salt, a hydroxide, a nitride, etc. of the elements contained in the silicon nitride-based sintered body. In addition to silicon nitride, examples of the powder raw material of the silicon nitride-based sintered body include magnesium carbonate, calcium carbonate, yttrium oxide, ytterbium oxide, erbium oxide, lanthanum oxide, and zirconium oxide.

Ethanol is added to the powder raw materials, and the mixture is wet-pulverized by means of a ball mill for, for example, 6 to 60 hours, to thereby yield a slurry. The slurry is dried by heating on a hot water bath or by means of a spray drier or the like, to thereby prepare a powder mixture.

Subsequently, the powder mixture is charged into a mold and shaped through monoaxial pressing at a pressure of, for example, 30 MPa, to thereby yield a molded body of desired shape. Thereafter, the molded body is subjected to a CIP treatment (cold isostatic pressing) at a pressure, for example, 150 MPa, to thereby yield a compact. The thus-obtained compact (i.e., a CIP press body) is subjected to, for example, the following process including placing the compact in a silicon carbide mold having an inside coating of BN and maintaining the compact at a maximum temperature of 1,800°C to 1, 900°C in a silicon carbide mold under nitrogen at 9 atm for 5 to 20 hours, for firing. Then, a silicon nitride-based sintered body can be obtained by cooling from the maximum temperature to 1,400°C at a cooling rate of, for example, 50°C/hr to 500°C/hr.

In the case where the silicon nitride-based sintered body is employed as a silicon nitride-based heat radiation substrate, the sintered body is processed so as to provide a predetermined outer shape having a specific thickness. Examples of the processing which may be employed include cutting, grinding, and blasting.

Through the aforementioned manufacturing method, there can be produced a silicon nitride-based sintered body or a silicon nitride-based heat radiation substrate which exhibits high mechanical strength, while high thermal conductivity is maintained.

### [Examples and Comparative Examples]

### (Sample 1)

Silicon nitride powder (average particle size: 1.4 µm), yttrium oxide powder (average particle size: 1.0 µm) in an amount of 3.0 wt%, magnesium carbonate powder (average particle size: 2.5 µm) in an amount of 3.0 wt%, and zirconium oxide powder (average particle size: 1.6 µm) in an amount of 1.0 wt% were weighed. The amounts of the latter three powders are based on the total amount of all the powders as 100 wt%. Next, the weighed powder raw materials were subjected to ball milling, to thereby prepare a mixed slurry. In ball milling, the powder raw materials and ethanol were put into a resin pot, and the mixture was pulverized by means of silicon nitride balls at 60 rpm for 16 hours. The thus-obtained mixed slurry was dried on a hot water bath, to thereby yield a powder mixture.

The obtained powder mixture was mono-axially pressed and subjected to CIP, to thereby form a compact. In a specific procedure, firstly, the powder mixture was charged into a specialized mold and then, conducting preliminary molding through mono-axial pressing at 30 MPa. Subsequently, the preliminary compact was put into a specialized bag, and CIP molding was conducted at 150 MPa while the bag was evacuated.

The thus-obtained compact was fired. In firing, the compact was maintained in an atmosphere of nitrogen (gas pressure: 9 atm) for 12 hours at a maximum temperature of 1,900°C. Then, the temperature was lowered from the maximum temperature to 1,400°C at a cooling rate of 200°C/hr. The mold employed in firing was a silicon carbide mold having an inside coating of BN. Thus, a silicon nitride-based sintered body of sample 1 was yielded.

### (Sample 2)

A silicon nitride-based sintered body of sample 2 was produced under the same conditions as those of sample 1, except that the amount of yttrium oxide powder was 5.0 wt% and the amount of magnesium carbonate powder was 4.0 wt%.

### (Sample 3)

A silicon nitride-based sintered body of sample 3 was produced under the same conditions as those of sample 2, except that the amount of magnesium carbonate powder was 6.0 wt%.

### (Sample 4)

A silicon nitride-based sintered body of sample 4 was produced under the same conditions as those of sample 2, except that the amount of magnesium carbonate powder was 3.0 wt%, and the time for maintaining the compact at the maximum temperature in firing was 6 hours.

### (Sample 5)

A silicon nitride-based sintered body of sample 5 was produced under the same conditions as those of sample 2, except that the time for maintaining the compact at the maximum temperature in firing was 9 hours.

### (Sample 6)

A silicon nitride-based sintered body of sample 6 was produced under the same conditions as those of sample 2, except that the time for maintaining the compact at the maximum temperature in firing was 18 hours.

### (Sample 7)

A silicon nitride-based sintered body of sample 7 was produced under the same conditions as those of sample 2, except that the time for mixing to form a mixed slurry was 24 hours.

### (Sample 8)

A silicon nitride-based sintered body of sample 8 was produced under the same conditions as those of sample 2, except that the time for mixing to form a mixed slurry was 36 hours.

### (Sample 9)

A silicon nitride-based sintered body of sample 9 was produced under the same conditions as those of sample 2, except that no zirconium oxide was added.

### (Sample 10)

A silicon nitride-based sintered body of sample 10 was produced under the same conditions as those of sample 2, except that yttrium oxide powder was changed to ytterbium oxide powder (average particle size: 1.2 µm).

### (Sample 11)

A silicon nitride-based sintered body of sample 11 was produced under the same conditions as those of sample 2, except that magnesium carbonate powder was changed to calcium carbonate powder (average particle size: 2.5 µm).

### (Sample 12)

A silicon nitride-based sintered body of sample 12 was produced under the same conditions as those of sample 1, except that the amount of yttrium oxide powder was 1.0 wt% and the amount of magnesium carbonate powder was 2.0 wt%.

### (Sample 13)

A silicon nitride-based sintered body of sample 13 was produced under the same conditions as those of sample 1, except that the amount of yttrium oxide powder was 7.0 wt% and the amount of magnesium carbonate powder was 10.0 wt%.

### (Sample 14)

A silicon nitride-based sintered body of sample 14 was produced under the same conditions as those of sample 2, except that the cooling rate was 500°C/hr.

### (Sample 15)

A silicon nitride-based sintered body of sample 15 was produced under the same conditions as those of sample 2, except that the cooling rate was 50°C/hr.

### (Sample 16)

A silicon nitride-based sintered body of sample 16 was produced under the same conditions as those of sample 8, except that the amount of yttrium oxide powder was 3.0 wt%, the amount of magnesium carbonate powder was 10.0 wt%, and firing was conducted using a silicon carbide mold placed in a silicon carbide case instead of a carbon case.

### [Measurements]

A sintered body produced as each sample was assessed through the following measurement procedures and the like.

### (Measurement of density)

The density of a sintered body of each sample was measured in accordance with JIS R1634.

### (Determination of percent area ratio of grain boundary phase)

The percent area ratio of the grain boundary phase was determined through observation under a SEM. In a specific procedure, a silicon nitride-based sintered body was processed through ion milling, and five sites in the processed surface were selected at random. A vision field (50 µm × 50 µm) at each site was observed at a magnification of 2,000. Areas of regions or grains which were recognized as the grain boundary phase observed in the five vision fields of the five sites were summed, and the ratio of the summed area to the entire area of the vision fields was calculated, to thereby determine a percent area ratio of the grain boundary phase.

### (Determination of area ratio of crystalline region)

Through observation under a STEM, whether the grain boundary phase was formed of the amorphous region A and the crystalline region C was determined, and the area ratio of the area of the crystalline region C with respect to the area of the grain boundary phase (%), C/(A+C)×100, was calculated. In a specific procedure, the same processed surface as employed in observation through SEM was observed under a STEM, and electron diffraction analysis was conducted with respect to the grain boundary phase, whereby the crystalline feature or amorphous feature of the grain boundary phase was determined, and the percent area ratio and area ratio of each region were calculated.

### (Identification of phase forming crystalline region)

Through XRD analysis, the phase forming the crystalline region C in the grain boundary phase of each sample was identified. However, identification of the phase forming the amorphous region was not conducted.

### (Calculation of thermal conductivity)

A sintered body of each sample was processed into pieces having dimensions of 0.32 mm × 17 mm × 17 mm. Thermal diffusivity of each piece was measured through a 2-dimensional laser flash method. A fixed specific heat value of 0.68 cm²/sec was employed. From the thermal diffusivity obtained through the dimensional method and density, thermal conductivity was calculated by an equation: (thermal conductivity)=(density)×(specific heat)×(thermal diffusivity).

### (Measurement of flexural strength)

In accordance with ISO 23242, a sintered body of each sample was processed to dimensions of 0.32 (thickness) × 12 × 25 mm, and the flexural strength was measured with a span of 15 mm by a three-point bending method.

### (Results)

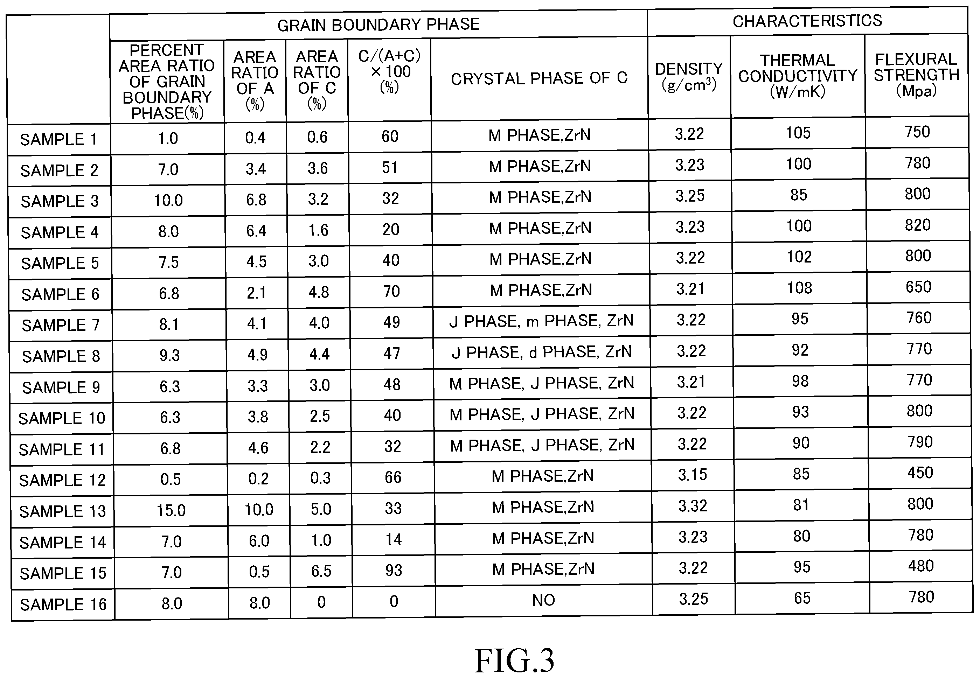

FIG. 3 is a table showing characteristics of the grain boundary phase of each sample, the substance forming the crystalline region, and characteristics of each sample. The samples 1 to 11 were found to exhibit a thermal conductivity of 85 W/mK or higher and a flexural strength of 500 MPa or higher. Thus, both high thermal conductivity and flexural strength were achieved.

The flexural strength of sample 12 was low. Such a low flexural strength was conceivably attributed to a grain boundary phase having a smaller area ratio caused by a small amount of additional agent. The thermal conductivity of sample 13 was low. Such a low thermal conductivity was conceivably attributed to a grain boundary phase having a greater area ratio caused by a large amount of additional agent.

The thermal conductivity of sample 14 was low. Such a low thermal conductivity was conceivably attributed to a smaller area ratio of the crystalline region with respect to the area of the grain boundary phase provided by a relatively high cooling rate. The flexural strength of sample 15 was low. Such a low flexural strength was conceivably attributed to a greater area ratio of the crystalline region with respect to the area of the grain boundary phase provided by a relatively low cooling rate.

Sample 16 was found to exhibit a very low thermal conductivity. A conceivable reason for this is that firing was conducted using a silicon carbide mold placed in a silicon carbide case instead of a carbon case, whereby crystallization of the grain boundary was incomplete.

The above-described results have revealed that the silicon nitride-based sintered body and the silicon nitride-based heat radiation substrate of the present invention can provide higher mechanical strength, while high thermal conductivity is maintained.

Needless to say, the present invention is not limited to the above-described embodiments and encompasses various modifications and equivalents included in the idea and scope of the present invention. In addition, the structures, shapes, numbers, positions, sizes, etc. of the constituent elements shown in the drawings are for the convenience of description and may be changed as appropriate.

### DESCRIPTION OF REFERENCE NUMERALS

10: silicon nitride-based heat radiation substrate
12: circuit layer
14: conductor layer
20: circuit substrate
22: solder
30: power semiconductor
40: heat radiation plate
42: grease
50: heat radiation member
100: power device

## Claims

1. A silicon nitride-based sintered body mainly comprising silicon nitride-based grains and a grain boundary phase surrounding the silicon nitride-based grains, wherein,
in a cross-section of the silicon nitride-based sintered body, a ratio of the area of the grain boundary phase to the entire area of the cross-section is 1% or greater and 10% or less;
the grain boundary phase is formed of an amorphous region A and a crystalline region C, and an area ratio of the area of the crystalline region C with respect to the area of the grain boundary phase, C/(A+C)×100, falls within a range of 20% or greater and 70% or less; and
a crystal phase forming the crystalline region C at least includes one or more of an M phase, a J phase, a monosilicate phase, and a disilicate phase.

2. The silicon nitride-based sintered body according to claim 1, wherein Al is included in an amount greater than 0 ppm and 650 ppm or less.

3. A silicon nitride-based heat radiation substrate **characterized by** being formed of a silicon nitride-based sintered body according to claim 1 or 2.

4. The silicon nitride-based heat radiation substrate according to claim 3, wherein thermal conductivity is 85 W/mK or higher.

5. The silicon nitride-based heat radiation substrate according to claim 3, wherein flexural strength is 500 MPa or higher.

6. The silicon nitride-based heat radiation substrate according to claim 3, wherein a thickness in a direction perpendicular to one main face of the silicon nitride-based heat radiation substrate is 220 µm or more and 690 µm or less.
